# FASCICULE DE BREVET EUROPEEN

(11) **EP 3 590 121 B1**
(45) Date de publication et mention de la délivrance du brevet: **01.11.2023**
(21) Numéro de dépôt: 18710086.2
(22) Date de dépôt: 23.02.2018
(51) Int. Cl.: H01H 9/16, H03M 11/24, H01H 9/06, B64C 13/04, B64C 27/56

(54) **SYSTÈME DE SURVEILLANCE REDONDANT ET DISSIMILAIRE DE L'ÉTAT DE CONTACTEURS DE COMMANDE D'UNE POIGNÉE DE COMMANDE D'UN AÉRONEF**
REDUNDANTES UND UNÄHNLICHES SYSTEM ZUR ÜBERWACHUNG DES STATUS VON STEUERSCHÜTZEN EINES FLUGZEUGSTEUERKNÜPPELS
REDUNDANT AND DISSIMILAR SYSTEM FOR MONITORING THE STATUS OF CONTROL CONTACTORS OF AN AIRCRAFT CONTROL STICK

(30) Priorité: 28.02.2017 FR 1700194
(43) Date de publication de la demande: 08.01.2020
(73) Titulaire: Airbus Helicopters, 13725 Marignane Cedex (FR)
(72) Inventeur: LAFFISSE, Jean-François, F-13008 Marseille (FR); IZZO, Pascal, F-13130 Berre L'Etang (FR)
(74) Mandataire: GPI & Associés
(86) Numéro de dépôt international: PCT/FR2018/000035
(87) Numéro de publication internationale: WO 2018/158511

(56) Documents cités:
- WO-A1-2018/087353
- JP-A- H0 447 617
- JP-A- 2010 188 862
- US-A1- 2007 164 168
- US-A1- 2009 012 659
- US-A1- 2012 112 558

## Description

La présente invention est du domaine des organes de commande d'un aéronef.

La présente invention concerne un système de surveillance redondant et dissimilaire de l'état de contacteurs de commande. La présente invention concerne également une poignée de commande comportant un système de surveillance redondant et dissimilaire de l'état de contacteurs.

Plus précisément, la présente invention permet la détection fiable de l'état d'un ou plusieurs contacteurs de commande d'une poignée de commande positionnée sur un organe de contrôle du vol d'un aéronef en prenant éventuellement en compte des contraintes de sécurité associées ainsi que la détection de défaillances sur un ou plusieurs de ces contacteurs de commande.

Un aéronef comporte des organes de contrôle de vol formés généralement par un manche et/ou un levier. L'utilisation d'organes de contrôle de type mini-manche ou joystick se développe également sur les aéronefs modernes. Chaque organe de contrôle comporte des contacteurs permettant au pilote de commander des fonctions importantes sans lâcher ces organes de contrôle. Ces contacteurs sont positionnés sur une poignée de commande de l'organe de contrôle, à savoir la poignée du manche ou bien du levier formant cet organe de contrôle, tel que décrit dans le document US 2009/0012659.

Par ailleurs, les fonctions disponibles dans les aéronefs se multiplient de sorte que le nombre de contacteurs présents aussi bien sur le tableau de bord que sur la poignée de commande de chaque organe de contrôle augmente.

On peut en outre noter que le nombre de contacteurs positionnés sur les poignées de commande des organes de contrôle est plus important sur un aéronef à voilure tournante que sur un aéronef à voilure fixe. En effet, un pilote d'un aéronef à voilure tournante utilise avec ses mains deux organes de contrôle distincts et il est plus problématique voire dangereux pour lui de lâcher ces organes de contrôle en cours de vol que pour un pilote d'un aéronef à voilure fixe. Dès lors, une poignée de commande d'un organe de contrôle d'un aéronef à voilure tournante peut comporter un nombre important de contacteurs compris par exemple entre quinze et vingt.

En conséquence, un faisceau électrique comportant un nombre important de câbles doit être implanté dans la poignée de commande afin d'assurer la connexion de ces contacteurs avec le système électrique et/ou électronique de l'aéronef, en particulier avec l'avionique de l'aéronef.

De plus, dans le cadre de fonctions considérées comme critiques et/ou sécuritaires, ces contacteurs sont redondés, comportant à ce titre au moins deux étages de commutation et étant reliés par des câbles également ségrégués.

De la sorte, le faisceau électrique assurant la connexion des contacteurs d'une poignée de commande avec l'avionique de l'aéronef comporte un nombre important de câbles pouvant être de l'ordre de quatre-vingt par exemple, voire davantage.

Ce nombre important de câbles constituant le faisceau électrique génère tout d'abord une contrainte de masse qui est un critère important pour un aéronef.

En outre, le faisceau électrique, qui transite à l'intérieur de la poignée de commande et de l'organe de contrôle, présente, vu ce nombre important de câbles, des dimensions qui peuvent être pénalisantes pour son implantation et son cheminement à l'intérieur de la poignée de commande et de l'organe de contrôle, en particulier pour les organes de contrôle de type mini-manche ou joystick. La mise en place ainsi que la maintenance de ce faisceau électrique est de fait plus difficile et complexe, en particulier lors de l'installation et/ou du changement d'une poignée de commande.

De plus, la mobilité et la flexibilité de ce faisceau électrique est réduite par ce nombre important de câbles et peut perturber le fonctionnement et les mouvements de l'organe de contrôle notamment s'il dispose d'un faible seuil d'effort, comme par exemple les organes de contrôle de type mini-manche. De la sorte, un effort de friction et de flexion dû au faisceau électrique peut apparaître dans les mouvements de l'organe de contrôle, impliquant alors une dégradation dans la précision du pilotage de l'aéronef.

Enfin, cette mobilité et cette flexibilité réduite de ce faisceau électrique peuvent générer lors des mouvements de l'organe de contrôle une dégradation accélérée et un endommagement d'un ou plusieurs câbles de ce faisceau électrique, susceptibles de provoquer la perte de certaines fonctions, ou tout au moins la perte de la commande de ces fonctions sur la poignée de commande.

Il apparaît donc important de réduire le nombre de câbles formant le faisceau électrique assurant la connexion des contacteurs d'une poignée de commande avec l'avionique, en particulier pour les organes de contrôle de type mini-manche qui tendent à se généraliser sur les aéronefs de dernière génération, afin de limiter les risques et les effets mentionnés ci-dessus.

Des solutions permettant de réduire le nombre de câbles formant ce faisceau électrique existent.

Par exemple, un système électronique analogique permet de multiplexer temporellement les informations fournies par chaque contacteur de la poignée de commande. Toutefois, un tel système électronique analogique multiplexé doit être intégré à l'intérieur de la poignée de commande, à savoir dans un volume réduit et limité, et dans un environnement exigeant en termes thermique, vibratoire et magnétique. De plus, une interface spécifique doit être créée afin d'acquérir les informations venant des contacteurs, ce qui pénalise la portabilité d'un tel système d'un aéronef à un autre. Enfin, ce système doit être qualifié et certifié selon les normes aéronautiques pour être utilisé dans une poignée de commande, en prenant en compte les fonctions considérées comme critiques et/ou sécuritaires commandées par ces contacteurs.

Une autre solution est l'installation dans la poignée de commande d'un concentrateur de données numériques réalisant l'acquisition de l'état des contacteurs et propageant ces informations au travers d'un bus numérique. Ce concentrateur de données numériques permet d'utiliser un faible nombre de câbles, mais présente tout de même des inconvénients en termes d'intégration dans la poignée de commande, notamment pour la dissipation thermique du concentrateur de données numériques et la prise en compte de l'environnement, avec ses contraintes thermiques, vibratoires et magnétiques. De plus, cette solution étant numérique, son intégration à l'intérieur de la poignée demande d'appliquer des processus de développement dans le respect des normes aéronautiques, par exemple les normes internationales DO178 et DO254, pour la prise en compte de fonctions considérées comme critiques et/ou sécuritaires.

Il est également possible d'utiliser un circuit résistif passif pour former un circuit de détection de la position de plusieurs inverseurs comme décrit dans le document EP 0638913. Les inverseurs, comportant trois bornes et deux positions, sont agencés en parallèle entre eux et une première résistance électrique est positionnée en série avec chaque inverseur, les premières résistances étant reliées entre elles par une de leurs extrémités. Au sein du circuit de détection, les premières bornes de tous les inverseurs sont reliées entre elles, de même que les deuxièmes bornes. Une source d'alimentation électrique est reliée aux lignes formées d'une part par les premières bornes et d'autre part par les deuxièmes bornes des inverseurs.

En outre, des résistances supplémentaires sont positionnées soit entre la première borne et la deuxième borne de chaque inverseur, soit entre deux premières résistances consécutives. Enfin, la tension électrique entre les lignes formées respectivement par les premières bornes des inverseurs et les premières résistances varie alors en fonction de la position de chaque inverseur de façon prédéterminée. De la sorte, un tel circuit de détection permet de détecter la position de chaque inverseur.

Toutefois, cette détection est réalisée sans hiérarchisation des inverseurs. De plus, cette détection est possible uniquement pour des inverseurs et ne fonctionne pas pour un simple interrupteur ou bien un bouton poussoir.

Dans le domaine automobile, des solutions ont également été développées pour l'implantation de boutons de commande sur un volant. Par exemple, les documents JP 2010/188862 et US 2012/0112558 décrivent des volants multifonction dont chaque bouton de commande est associé à un interrupteur relié électriquement à une résistance, les résistances étant agencées en série et chaque interrupteur étant ainsi agencé en parallèle d'une ou plusieurs résistances.

De plus, selon le document US 2012/0112558, le volant multifonction comporte une unité de commande mesurant des tensions électriques internes et déterminant l'interrupteur actionné. Cette unité de commande envoie alors un signal électrique de sortie avec une tension électrique correspondant à cet interrupteur.

On connaît également le document JP H04 47617 qui décrit un appareil muni de touches, tel qu'un téléphone ou bien une télécommande. Chaque touche agit sur un interrupteur relié électriquement et en parallèle à une résistance. Les résistances sont agencées en série et ont des valeurs différentes.

On connaît également le document US 2007/0164168 qui divulgue un système de surveillance redondant et dissimilaire de l'état de contacteurs de commande, ledit système de surveillance comportant :
- au moins une source d'alimentation électrique générant un courant électrique avec une tension électrique d'alimentation,
- au moins un calculateur,
- une pluralité de contacteurs de commande, chaque contacteur de commande comportant plusieurs interrupteurs pilotés simultanément, et
- au moins deux circuits de surveillance de l'état desdits interrupteurs desdits contacteurs de commande.

La présente invention a alors pour but de fournir une solution de surveillance de l'état d'interrupteurs basée sur un dispositif électronique analogique passif et simple, adaptable facilement à une poignée de commande et utilisant des composants standards.

Dans ce cadre, la présente invention propose un système de surveillance de l'état de contacteurs de commande d'une poignée de commande permettant de s'affranchir des limitations mentionnées ci-dessus et permettant la détection fiable de l'état d'un ou plusieurs contacteurs de commande ainsi que la détection de défaillances sur un ou plusieurs de ces contacteurs de commande. L'invention a aussi pour objet une poignée de commande d'un organe de vol d'un aéronef muni d'un tel système de surveillance.

Selon l'invention, un système de surveillance redondant et dissimilaire de l'état de contacteurs de commande comporte :
- au moins une source d'alimentation électrique générant un courant électrique avec une tension électrique d'alimentation *V_{A}*,
- au moins un calculateur,
- une pluralité de contacteurs de commande, chaque contacteur de commande comportant plusieurs interrupteurs pilotés simultanément, et
- au moins deux circuits de surveillance de l'état des interrupteurs des contacteurs de commande, un interrupteur de chaque contacteur de commande étant intégré à un circuit de surveillance, chaque circuit de surveillance étant relié à au moins une source d'alimentation électrique et à au moins un calculateur, chaque circuit de surveillance comportant :
   - un ensemble électronique muni d'un récepteur de pied et d'au moins deux récepteurs de contrôle agencés en série entre eux, chaque récepteur de contrôle étant muni respectivement de deux bornes primaires, et
   - au moins deux interrupteurs munis respectivement de deux bornes secondaires, une première borne secondaire d'un interrupteur étant reliée électriquement à une première borne primaire d'un récepteur de contrôle et chaque interrupteur étant agencé en parallèle avec au moins un récepteur de contrôle de sorte à court-circuiter le au moins un récepteur de contrôle lorsque l'interrupteur est à l'état fermé, le nombre d'interrupteurs étant égal au nombre de récepteurs de contrôle.

Ce système de surveillance de l'état de contacteurs de commande selon l'invention est notamment destiné aux poignées de commande des organes de vol d'un aéronef et notamment d'un aéronef à voilure tournante.

Ce système de surveillance de l'état de contacteurs de commande selon l'invention est remarquable en ce que chaque calculateur est configuré afin de mesurer au moins une caractéristique électrique de l'ensemble électronique et de déterminer l'état des interrupteurs et des contacteurs de commande du système de surveillance.

Dans le système de surveillance redondant et dissimilaire selon l'invention, les circuits de surveillance sont agencés en parallèle. De la sorte, le système de surveillance selon l'invention permet avantageusement de surveiller et de détecter une action sur un contacteur de commande, correspondant à un changement d'état de ses interrupteurs par l'intermédiaire de chaque circuit de surveillance des interrupteurs des contacteurs de commande de façon redondante garantissant une détection de cette action y compris en cas de panne d'un des interrupteurs du contacteur de commande et/ou d'un de ces circuits de surveillance.

De plus, au moins deux circuits de surveillance sont dissimilaires. On entend par « circuits de surveillance dissimilaires » des circuits de surveillance différents, ayant des architectures électriques et plus précisément, des implantations des récepteurs de contrôle et/ou des interrupteurs différents. De la sorte, les circuits de surveillance dissimilaires ne sont pas impactés de façon identique par une défaillance ou bien une panne en particulier lorsque cette défaillance ou bien cette panne concerne un contacteur de commande ou bien un de ces interrupteurs. Cette dissimilarité d'au moins deux circuits de surveillance permet avantageusement de pallier une telle défaillance ou une telle panne sans remettre en cause le fonctionnement et l'efficacité du système de surveillance selon l'invention.

Cette redondance et cette dissimilarité de la surveillance de l'état de contacteurs sont obtenues tout en minimisant avantageusement le nombre de câbles constituant le faisceau électrique utilisé afin de relier le système de surveillance redondant à l'avionique de l'aéronef. En effet, ce nombre de câbles de ce faisceau électrique est lié au nombre de circuits de surveillance que contient ce système de surveillance redondant, indépendamment du nombre de contacteurs de commande.

En conséquence, le système de surveillance redondant et dissimilaire selon l'invention permet avantageusement de limiter la masse et le volume de ce faisceau électrique ainsi que de faciliter son implantation à l'intérieur d'une poignée de commande et d'un organe de contrôle, en particulier pour un organe de contrôle de type mini-manche ou joystick. De plus, ce faisceau électrique dispose, grâce à ce faible nombre de câbles, d'une grande mobilité et d'une grande flexibilité, quel que soit le nombre d'interrupteurs surveillés, et ne perturbe donc pas le fonctionnement et les mouvements de l'organe de contrôle.

Enfin, ce faible nombre de câbles permet de garantir la fiabilité du fonctionnement du système de surveillance en évitant une dégradation et un endommagement d'un ou plusieurs câbles de ce faisceau électrique lors des mouvements de l'organe de contrôle.

Le système de surveillance redondant peut comporter une ou plusieurs sources d'alimentation électriques générant un courant électrique avec une tension électrique d'alimentation *V_{A}* afin d'alimenter chaque circuit de surveillance. De préférence, le système de surveillance comporte au moins deux sources d'alimentation électrique pour assurer une redondance de l'alimentation électrique des circuits de surveillance.

Par exemple, le système de surveillance comporte plusieurs sources d'alimentation électrique, et chaque source d'alimentation électrique est utilisée pour alimenter au moins deux circuits de surveillance. En conséquence, en cas de panne d'une source d'alimentation électrique, chaque circuit de surveillance est toujours alimenté par au moins une source d'alimentation électrique et reste donc opérationnel. Chaque source d'alimentation électrique permet ainsi de pallier une panne d'une autre source d'alimentation électrique.

Entre outre, une source d'alimentation électrique peut être formée par plusieurs générateurs agencés en parallèle. De la sorte, une panne d'un générateur peut être palliée par au moins un autre générateur.

Un contacteur de commande est par exemple un interrupteur à levier à deux positions, un bouton directionnel à quatre directions ou bien un bouton poussoir. Chaque contacteur de commande comporte un ou plusieurs interrupteurs, tous ces interrupteurs d'une série étant pilotés de façon simultanée. Chaque interrupteur d'une telle série est intégré respectivement à un circuit de surveillance spécifique.

Chaque interrupteur comporte deux bornes secondaires et deux positions correspondant à deux états de l'interrupteur. Un état ouvert correspond à une position ouverte de l'interrupteur, dans laquelle l'interrupteur ne permet pas une liaison électrique entre ses deux bornes secondaires. Un état fermé correspond à une position fermée de l'interrupteur, dans laquelle l'interrupteur assure une liaison électrique entre ses deux bornes secondaires.

Un contacteur de commande comporte par exemple deux interrupteurs, chaque interrupteur pouvant être utilisé dans un état normalement ouvert, à savoir qu'il est en position ouverte au repos et ne permet pas une liaison électrique tant que le contacteur de commande n'est pas actionné, ou bien dans un état normalement fermé et permet une liaison électrique tant que le contacteur de commande n'est pas actionné.

Pour chaque circuit de surveillance du système de surveillance redondant et dissimilaire selon l'invention, chaque interrupteur est agencé en parallèle avec au moins un récepteur de contrôle. En conséquence, un changement d'état d'un interrupteur permet de modifier au moins une caractéristique électrique de l'ensemble électronique de ce circuit de surveillance, et en particulier sa résistance électrique. Par exemple, le passage de l'état ouvert à l'état fermé permet de court-circuiter au moins un récepteur de contrôle. De la sorte, chaque récepteur de contrôle court-circuité n'est pas traversé par un courant électrique ce qui modifie au moins une caractéristique électrique de l'ensemble électronique.

Inversement, le passage de l'état fermé à l'état ouvert d'un interrupteur permet de supprimer le court-circuit appliqué à au moins un récepteur de contrôle. De fait, chaque récepteur de contrôle précédemment court-circuité est à présent traversé par un courant électrique ce qui modifie également au moins une caractéristique électrique de l'ensemble électronique.

En conséquence, une modification de l'état d'un interrupteur provoque un changement d'au moins une caractéristique électrique de l'ensemble électronique du circuit de surveillance. Une analyse de ce changement d'au moins une caractéristique électrique de l'ensemble électronique permet de déterminer quel récepteur de contrôle a été court-circuité et d'en déduire avantageusement l'interrupteur qui a changé d'état et son nouvel état.

Chaque calculateur est configuré afin de mesurer au moins une caractéristique électrique de l'ensemble électronique d'au moins un circuit de surveillance et éventuellement une caractéristique électrique d'au moins un circuit de surveillance. Dans ce but, chaque calculateur peut comporter un dispositif de mesure. La mesure de cette caractéristique électrique de l'ensemble électronique peut ensuite être utilisée par chaque calculateur afin de déterminer l'état d'au moins un interrupteur. La mesure de cette caractéristique électrique de l'ensemble électronique et son traitement sont effectués de façon continue ou bien à intervalles de temps réguliers.

De la sorte, au moins une caractéristique électrique de l'ensemble électronique d'au moins un circuit de surveillance, telle sa résistance électrique ou bien une tension électrique caractérisant l'ensemble électronique, variant avec l'état des interrupteurs de ce circuit de surveillance, est mesurée par chaque calculateur du système de surveillance selon l'invention. De plus, des valeurs spécifiques d'au moins cette caractéristique électrique de l'ensemble électronique peuvent être définies préalablement en fonction de l'état de chaque interrupteur. Ce sont ces valeurs spécifiques de la caractéristique électrique de l'ensemble électronique que le calculateur compare avec la caractéristique électrique de l'ensemble électronique mesurée par le dispositif de mesure afin de l'état d'au moins un interrupteur.

Dans ce but, le calculateur peut comporter une mémoire dans laquelle sont stockés d'une part ces valeurs spécifiques d'au moins une caractéristique électrique de l'ensemble électronique et d'autre part un algorithme de comparaison de ces valeurs spécifiques avec chaque caractéristique électrique de l'ensemble électronique mesurée par le calculateur.

De préférence, la caractéristique électrique de l'ensemble électronique mesurée par le dispositif de mesure est une tension électrique permettant de caractériser l'ensemble électronique du circuit de surveillance.

Le calculateur peut comporter un dispositif d'analyse afin d'analyser chaque caractéristique électrique mesurée et de la comparer avec des valeurs spécifiques.

De plus, une tension électrique de référence *V_{A'}* peut être mesurée aux bornes de chaque circuit de surveillance par au moins un calculateur, cette tension électrique *V_{A'}* correspondant sensiblement à la tension électrique d'alimentation *V_{A}* générée par une source d'alimentation électrique. Cet au moins un calculateur, qui a également mesuré la tension électrique caractérisant l'ensemble électronique, peut alors comparer le rapport de cette tension électrique caractérisant l'ensemble électronique par la tension électrique de référence *V_{A'}* à des valeurs spécifiques prédéfinies afin de déterminer l'état d'au moins un interrupteur.

De la sorte, toute variation ou perturbation de la tension électrique d'alimentation *V_{A}* générée par une source d'alimentation électrique est avantageusement prise en compte afin d'éviter une erreur liée à une telle variation ou perturbation de la tension électrique d'alimentation *V_{A}*. Cette erreur pourrait être par exemple une non détection d'un changement d'état d'un interrupteur, une erreur dans l'identification de l'interrupteur ayant changé d'état ou bien une fausse détection d'un changement d'état d'un interrupteur, à savoir un changement d'état n'ayant pas eu lieu. Une variation ou perturbation de la tension électrique d'alimentation *V_{A}* peut par exemple être due à une variation de la température ou bien à la présence d'une résistance parasite sur le circuit d'alimentation ou encore à un défaut sur une source d'alimentation électrique.

Cette tension électrique caractérisant l'ensemble électronique est par exemple une première tension électrique de réseau *V_{E}* mesurée aux bornes de l'ensemble électronique, au moins un calculateur étant relié électriquement aux bornes de l'ensemble électronique. Le circuit de surveillance comporte alors un récepteur de tête agencé en série avec l'ensemble électronique et positionné par exemple entre chaque source d'alimentation électrique et l'ensemble électronique. Ce récepteur de tête permet notamment de définir en combinaison avec l'ensemble électronique une première tension électrique de réseau *V_{E}* aux bornes de l'ensemble électronique différente de la tension électrique de référence *V*_{*A*'}. Sans action sur les contacteurs de commande, cette tension électrique de référence *V_{A'}* permet de surveiller l'état électrique des récepteurs de contrôle qui ne sont pas court-circuités par les interrupteurs. De préférence, le récepteur de tête est un dipôle passif purement résistif, telle une résistance électrique.

Cette tension électrique caractérisant l'ensemble électronique peut également être une seconde tension électrique de réseau *V_{R}* mesurée aux bornes du récepteur de pied, au moins un calculateur étant relié électriquement aux bornes du récepteur de pied.

Dans ces deux cas, au moins un calculateur peut être configuré afin de déterminer l'état des interrupteurs et des contacteurs de commande directement à partir de cette tension électrique caractérisant l'ensemble électronique. Au moins un calculateur peut également être configuré afin de déterminer, comme précédemment décrit, un rapport de la tension électrique caractérisant l'ensemble électronique par la tension électrique de référence *V_{A'}* aux bornes du circuit de surveillance et d'en déduire l'état des interrupteurs et des contacteurs de commande.

De façon générale, un ensemble électronique comporte *n* récepteurs de contrôle et *n* interrupteurs, *n* étant un nombre entier positif supérieur ou égal à *2.* Par hypothèse, on considère qu'un interrupteur de rang *i, i* étant compris entre *1* et *n,* est situé en amont d'un interrupteur de rang *(i+1)* et en aval d'un interrupteur de rang *(i-1)* en prenant en compte la position de l'alimentation électrique comme point le plus amont.

L'interrupteur de rang *1* est donc le plus proche de la source d'alimentation électrique et l'interrupteur de rang n le plus éloigné.

Chaque récepteur, qu'il s'agisse d'un récepteur de contrôle ou du récepteur de pied, comporte au moins un dipôle électronique, telle une diode ou bien une résistance par exemple. Chaque récepteur comporte de préférence un ou plusieurs dipôles passifs et purement résistifs. Dans le cas où chaque dipôle électronique de ces récepteurs est une diode, chaque récepteur comporte de préférence deux diodes et chaque circuit de surveillance comporte un récepteur de tête comportant au moins une résistance électrique afin de limiter le courant électrique circulant dans le circuit de surveillance.

Selon un premier mode de réalisation d'un circuit de surveillance du système de surveillance selon l'invention, une seconde borne secondaire d'un interrupteur est reliée électriquement à une seconde borne primaire d'un récepteur de contrôle. De la sorte, les interrupteurs sont agencés en série entre eux et chaque interrupteur est agencé en parallèle avec un seul récepteur de contrôle afin de court-circuiter ce récepteur de contrôle lorsque l'interrupteur est à l'état fermé.

En conséquence, chaque interrupteur permet de court-circuiter un seul récepteur de contrôle situé en parallèle de cet interrupteur et indépendamment des autres récepteurs de contrôle du circuit de surveillance, modifiant alors au moins une caractéristique électrique de l'ensemble électronique. En conséquence, chaque calculateur permet avantageusement d'identifier des changements d'états simultanés de plusieurs interrupteurs.

Dans le cas où les récepteurs de contrôle sont sensiblement identiques en termes de caractéristiques électriques, telles que leurs résistances électriques par exemple, le calculateur permet de déterminer le nombre d'interrupteurs ayant changé d'état entre deux mesures successives ou bien sur une période de temps prédéfinie ainsi que le nombre d'interrupteurs à chaque état, à savoir à l'état ouvert et à l'état fermé.

Dans le cas où les récepteurs de contrôle sont différents en termes de caractéristiques électriques et définis de sorte que les valeurs spécifiques d'au moins une caractéristique électrique de l'ensemble électronique sont différentes pour chaque état de chaque interrupteur, le calculateur permet également d'identifier avantageusement l'état de chaque interrupteur.

De plus, selon ce premier mode de réalisation, un circuit de surveillance permet d'utiliser comme interrupteur aussi bien un interrupteur normalement ouvert, à savoir permettant la création d'une liaison électrique lorsqu'il est actionné, ou bien normalement fermé, à savoir permettant la coupure de la liaison électrique lorsqu'il est actionné.

Selon un deuxième mode de réalisation d'un circuit de surveillance du système de surveillance selon l'invention, les interrupteurs sont agencés en parallèle entre eux, une seconde borne secondaire de chaque interrupteur étant reliée électriquement à une seconde borne secondaire des autres interrupteurs. De la sorte, chaque interrupteur de rang i est agencé en parallèle avec *(n*-*i+1)* récepteur(s) de contrôle afin de court-circuiter ces *(n-i+1)* récepteur(s) de contrôle et *(n-i)* interrupteur(s) de rang supérieur au rang *i* lorsque l'interrupteur de rang *i* est à l'état fermé.

Chaque interrupteur permet, à l'état fermé, de court-circuiter simultanément un ou plusieurs récepteurs de contrôle ainsi qu'éventuellement un ou plusieurs interrupteurs situés en parallèle et en aval de cet interrupteur. Chaque interrupteur permet donc de rendre ces interrupteurs « aval » sans effet sur le circuit de surveillance. En conséquence, ce deuxième mode de réalisation permet avantageusement de créer une hiérarchisation des interrupteurs, un interrupteur ayant un niveau hiérarchique supérieur à un interrupteur situé en aval de lui et un niveau hiérarchique inférieur à un interrupteur situé en amont de lui.

En conséquence, le calculateur permet d'identifier l'état fermé d'un seul interrupteur à la fois. En effet, chaque interrupteur en aval de cet interrupteur à l'état fermé est court-circuité et donc non détecté alors que les interrupteurs en amont sont à l'état ouvert.

Par exemple, si deux interrupteurs passent à l'état fermé simultanément, seul le changement d'état de l'interrupteur avec le niveau hiérarchique le plus élevé, à savoir le plus en amont, sera détecté par le calculateur.

Un circuit de surveillance selon ce deuxième mode de réalisation fonctionne de façon similaire que les récepteurs de contrôle soient différents ou bien qu'ils soient sensiblement identiques en termes de caractéristiques électriques. Toutefois, les récepteurs de contrôle sont de préférence sensiblement identiques afin notamment de faciliter la définition des valeurs spécifiques de la caractéristique électrique de l'ensemble électronique, qui sont alors proportionnelles.

De préférence, selon ce deuxième mode de réalisation, un circuit de surveillance comporte des interrupteurs normalement ouverts. Toutefois, des interrupteurs normalement fermés peuvent également être utilisés, en prenant en compte leurs niveaux hiérarchiques. Dans ce cas, toute action sur un interrupteur aval à un interrupteur normalement fermé sera sans effet sur les caractéristiques électriques de l'ensemble électronique et donc non détectée tant que cet interrupteur normalement fermé ne passera pas l'état ouvert.

Un troisième mode de réalisation d'un circuit de surveillance d'un système de surveillance selon l'invention est obtenu en combinant le premier mode de réalisation et le deuxième mode de réalisation. Les interrupteurs de rang *j, j* étant un nombre entier positif compris entre *1* et *m, m* étant un nombre entier positif compris entre *1* et *n,* sont agencés en série entre eux, selon le premier mode de réalisation, de sorte que chaque interrupteur de rang *j* soit agencé en parallèle avec un seul récepteur de contrôle afin de court-circuiter ce récepteur de contrôle lorsque l'interrupteur de rang *j* est à l'état fermé. Les interrupteurs de rang *k, k* étant un nombre entier positif compris entre *(m+1)* et *n,* sont agencés en parallèle entre eux selon le deuxième mode de réalisation, une seconde borne secondaire de chaque interrupteur de rang *k* étant reliée électriquement à une seconde borne secondaire des interrupteurs de rang *(m+1)* à *n,* de sorte que chaque interrupteur de rang *k* est agencé en parallèle avec *(n-k+1)* récepteur(s) de contrôle afin de court-circuiter ces *(n-k+1)* récepteur(s) de contrôle et *(n-k)* interrupteur(s) de rang supérieur au rang *k* lorsque l'interrupteur de rang *k* est à l'état fermé.

Quel que soit le mode de réalisation, chaque circuit de surveillance permet avantageusement de minimiser le nombre de câbles constituant le faisceau électrique utilisé afin de relier le système de surveillance à l'avionique de l'aéronef et de surveiller ainsi l'état de l'ensemble des interrupteurs. De plus, ce nombre de câbles est indépendant du nombre d'interrupteurs à surveiller.

Le système de surveillance selon l'invention peut alors comporter au moins deux circuits de surveillance selon respectivement au moins deux de ces modes de réalisation permettant ainsi la présence d'au moins deux circuits de surveillance dissimilaires.

De plus, le système de surveillance selon l'invention peut également comporter au moins un contacteur de commande dont au moins deux interrupteurs ont des états différents au repos ainsi qu'au moins deux circuits de surveillance reliés à ces au moins deux interrupteurs. De la sorte, ces au moins deux circuits de surveillance sont différents et dissimilaires.

Le système de surveillance garantit ainsi, quel que soit le mode de réalisation et grâce à la redondance et la dissimilarité des circuit de surveillance, une très bonne testabilité des interrupteurs des contacteurs de commande en permettant la détection de différents modes de pannes de ces interrupteurs, notamment lorsque la caractéristique électrique de l'ensemble électronique mesurée ne correspond à aucune des valeurs spécifiques de cette caractéristique électrique définies pour le changement d'état de chaque interrupteur. Avantageusement, le système de surveillance selon l'invention permet également la localisation d'une panne dans un circuit de surveillance.

Les modes de pannes détectés sont par exemple une panne d'un interrupteur au démarrage du circuit de surveillance, la caractéristique électrique de l'ensemble électronique mesurée ne correspondant alors pas à la valeur spécifique de l'état de repos initial connu. Un court-circuit ou bien un circuit ouvert sur un récepteur de contrôle peut également être détecté par duplication du récepteur de contrôle en par exemple deux sous-récepteurs. De la sorte, une panne, telle qu'un court-circuit, sur un des deux sous-récepteurs entraîne une caractéristique électrique de l'ensemble électronique mesurée ne correspondant alors à aucune valeur spécifique.

Un interrupteur qui reste « collé » malgré une action sur le contacteur de commande ou bien après l'arrêt d'une telle action est également avantageusement détecté, en particulier grâce à l'utilisation simultanée sur deux circuits de surveillance différents d'un interrupteur normalement fermé et d'un interrupteur normalement ouvert pour un même contacteur de commande.

L'utilisation d'une source d'alimentation électrique générant une tension électrique stable est préférable pour détecter ces pannes de façon fiable et éviter la détection de fausses pannes. Toutefois, l'utilisation du rapport entre la tension électrique caractérisant l'ensemble électronique et la tension électrique de référence *V_{A'}* aux bornes du circuit de surveillance permet de pallier toute variation ou perturbation de la tension électrique d'alimentation *V_{A}* générée par la source d'alimentation électrique.

La présente invention a aussi pour objet une poignée de commande d'un organe de vol d'un aéronef comportant une poignée et des contacteurs de commande ainsi qu'un système de surveillance redondant et dissimilaire de l'état de contacteurs de commande tel que précédemment décrit. Une ou plusieurs sources d'alimentation électrique du système de surveillance peuvent être agencées en dehors de la poignée de commande. De même, un ou plusieurs calculateurs du système de surveillance peuvent être agencés en dehors de la poignée de commande.

De plus, chaque source d'alimentation électrique et chaque calculateur peuvent être utilisés de façon commune et redondante par plusieurs poignées de commande comportant un tel système de surveillance redondant et dissimilaire de l'état de contacteurs de commande. La présente invention permet de connecter plusieurs calculateurs à un même système de surveillance.

L'invention et ses avantages apparaîtront avec plus de détails dans le cadre de la description qui suit avec des exemples de réalisation donnés à titre illustratif en référence aux figures annexées qui représentent :
- la figure 1, une poignée de commande d'un organe de vol d'un aéronef, et
- les figures 2 à 3, deux exemples d'un système de surveillance redondant et dissimilaire de l'état de contacteurs de commande.

Les éléments présents dans plusieurs figures distinctes sont affectés d'une seule et même référence.

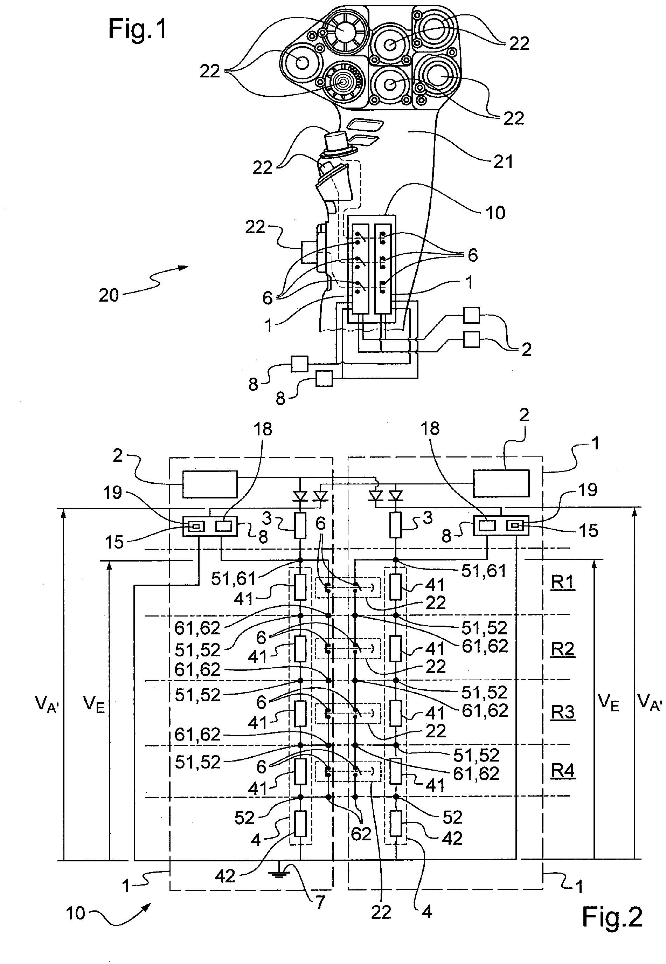

Sur la figure 1, une poignée de commande 20 est représentée. Cette poignée de commande 20 comporte une poignée 21 et un système de surveillance 10 redondant et dissimilaire de l'état de contacteurs de commande 22, ce système de surveillance 10 étant muni de contacteurs de commande 22 et de deux circuits de surveillance 1 de l'état des interrupteurs 6 des contacteurs de commande 22. Cette poignée de commande 20 est positionnée à l'extrémité d'un organe de contrôle (non représenté) du vol d'un aéronef, tel un manche, un levier ou bien un joystick par exemple. Chaque contacteur de commande 22 comporte deux d'interrupteurs 6 pilotés de façon simultanée de sorte que les deux interrupteurs d'un contacteur de commande 22 changent d'état simultanément lors d'une action sur le contacteur de commande 22. Chaque circuit de surveillance 1 comporte un interrupteur 6 de chaque contacteur de commande 22.

Deux exemples d'un système de surveillance 10 redondant et dissimilaire de l'état de contacteurs de commande 22 sont représentés sur les figures 2 à 3.

De façon commune à ces deux exemples, un système de surveillance 10 comporte deux sources d'alimentation électrique 2, deux calculateurs 8 et deux circuits de surveillance 1. Chaque circuit de surveillance 1 comporte plusieurs interrupteurs 6 et un ensemble électronique 4 muni de plusieurs récepteurs de contrôle 41 et d'un récepteur de pied 42.

Le calculateur 8 comporte un dispositif de mesure 18, un dispositif d'analyse 19 et une mémoire 15.

Chaque source d'alimentation électrique 2 est reliée électriquement aux deux circuits de surveillance 1 et génère dans chaque circuit de surveillance 1 un courant électrique avec une tension électrique d'alimentation *V_{A}.* Chaque calculateur 8 est relié électriquement à au moins un circuit de surveillance 1 afin de mesurer, par l'intermédiaire du dispositif de mesure 18, au moins une caractéristique électrique de l'ensemble électronique 4 d'un circuit de surveillance 1 et au moins une caractéristique électrique d'un circuit de surveillance 1.

Une caractéristique électrique mesurée d'un ensemble électronique 4 est par exemple une tension électrique caractérisant cet ensemble électronique 4. De même, une caractéristique électrique d'un circuit de surveillance 1 est par exemple une tension électrique de référence *V_{A'}* mesurée aux bornes de ce circuit de surveillance 1.

L'ensemble électronique 4 de chaque circuit de surveillance 1 comporte un récepteur de pied 42 et plusieurs récepteurs de contrôle 41 agencés en série, le nombre de récepteurs de contrôle 41 étant égal au nombre d'interrupteurs 6 de ce circuit de surveillance 1. Chaque récepteur de contrôle 41 est muni de deux bornes primaires 51,52 et est par exemple un dipôle passif purement résistif. Chaque interrupteur 6 est muni de deux bornes secondaires 61,62 et comporte deux positions correspondant respectivement à un état ouvert et à un état fermé de l'interrupteur 6.

De façon générale, chaque récepteur de contrôle 41 et chaque interrupteur 6 peuvent être identifiés par leur rang vis-à-vis de la position des sources d'alimentation électrique 2. Ainsi, un récepteur de contrôle 41 et un interrupteur 6 de rang *R1* sont le récepteur de contrôle 41 et l'interrupteur 6 les plus proches des sources d'alimentation électrique 2. Inversement, un récepteur de contrôle 41 et un interrupteur 6 de rang *Rn, n* étant le nombre de récepteurs de contrôle 41 et le nombre d'interrupteurs 6, sont le récepteur de contrôle 41 et l'interrupteur 6 les plus éloignés des sources d'alimentation 2.

Pour ces deux exemples d'un système de surveillance 10, les deux circuits de surveillance 1 de chaque système de surveillance 10 sont dissimilaires, c'est-à-dire que leurs architectures électriques sont différentes, les implantations des récepteurs de contrôle 41 et/ou des interrupteurs 6 étant différentes.

Selon un premier exemple d'un système de surveillance 10 représenté sur la figure 2, les architectures électriques des deux circuits de surveillance 1 diffèrent uniquement par l'état au repos des interrupteurs 6 de chaque contacteur de commande 22.

Chaque circuit de surveillance 1 comporte une récepteur de tête 3, quatre interrupteurs 6 et un ensemble électronique 4 formé par un récepteur de pied 42 et quatre récepteurs de contrôle 41. Le récepteur de tête 3 est agencé en série avec le récepteur de pied 42 et les quatre récepteurs de contrôle 41 et placé en amont de l'ensemble électronique 4. Ce récepteur de tête 3 est par exemple une résistance électrique. Chaque interrupteur 6 est positionné en parallèle d'un récepteur de contrôle 41, chaque borne secondaire 61,62 d'un interrupteur 6 étant reliée électriquement respectivement à une borne primaire 51,52 de ce récepteur de contrôle 41. De la sorte, les interrupteurs 6 sont agencés en série entre eux. La seconde borne primaire 52 du récepteur de contrôle 41 de rang *R4* et la seconde borne secondaire 62 de l'interrupteur 6 de rang *R4* sont reliées électriquement au récepteur de pied 42, qui est lui-même relié électriquement à une masse 7 du circuit de surveillance 1.

Pour un circuit de surveillance 1, les interrupteurs 6 sont à l'état ouvert au repos, à savoir que chaque interrupteur 6 est en position ouverte tant qu'aucune action n'est exercée sur le contacteur de commande 22 correspondant, alors que, pour l'autre circuit de surveillance 1, les interrupteurs 6 sont à l'état fermé au repos, à savoir que chaque interrupteur 6 est en position fermée tant qu'aucune action n'est exercée sur le contacteur de commande 22 correspondant.

En conséquence, chaque interrupteur 6 à l'état fermé court-circuite le récepteur de contrôle 41 situé en parallèle de cet interrupteur 6 quel que soit l'état des autres interrupteurs 6.

De plus, les récepteurs de contrôle 41 ont des caractéristiques électriques, et en particulier des résistances électriques, spécifiques et différentes de sorte que la résistance électrique de l'ensemble électronique 4 varie et est égale à des valeurs différentes pour chaque état de chaque interrupteur 6. A partir de ces différentes valeurs de la résistance électrique de l'ensemble électronique 4, des valeurs spécifiques de la première tension électrique de réseau *V_{E}* aux bornes de l'ensemble électronique 4 sont préalablement définies pour chaque état de chaque interrupteur 6, en fonction de la tension électrique d'alimentation *V_{A}*, de la résistance électrique du récepteur de tête 3 et de l'état de chaque interrupteurs 6 de ce premier circuit de surveillance 1a. Des rapports spécifiques de la première tension électrique de réseau *V_{E}* par la tension électrique d'alimentation *V_{A}* correspondant aux différents états de chaque interrupteur 6 sont stockées dans la mémoire 15.

Chaque calculateur 8 est relié électriquement à un seul circuit de surveillance 1. Dès lors, chaque calculateur 8 permet de mesurer, par l'intermédiaire de leur dispositif de mesure 18 respectif, la première tension électrique de réseau *V_{E}* aux bornes de l'ensemble électronique 4 du circuit de surveillance 1 auquel il est relié ainsi que la tension électrique de référence *V_{A'}* mesurée aux bornes de ce circuit de surveillance 1. Chaque calculateur 8 permet ensuite de comparer, par l'intermédiaire de leur dispositif d'analyse 19 respectif, le rapport de cette première tension électrique de réseau *V_{E}* par la tension électrique de référence *V_{A'}* avec ces rapports spécifiques afin d'identifier l'état de chaque interrupteur 6, quel que soit son rang et quel que soit son état ouvert ou bien fermé.

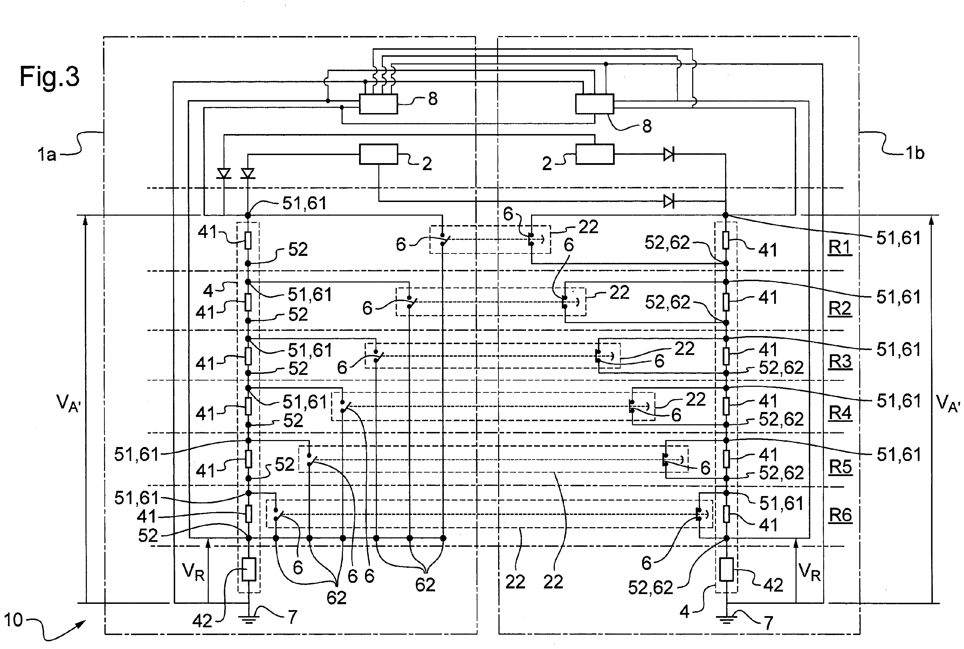

Selon un deuxième exemple d'un système de surveillance 10 représenté sur la figure 3, les architectures électriques des deux circuits de surveillance 1 diffèrent d'une part par l'implantation des interrupteurs 6 de chaque contacteur de commande 22 et d'autre part par l'état au repos de ces interrupteurs 6. Chaque circuit de surveillance 1 comporte un récepteur de pied 42, six récepteurs de contrôle 41 et six interrupteurs 6.

Chaque calculateur 8 est relié électriquement aux deux circuits de surveillance 1 afin de mesurer, par l'intermédiaire du dispositif de mesure 18, au moins une caractéristique électrique de l'ensemble électronique 4 de chaque circuit de surveillance 1 et une caractéristique électrique de chaque circuit de surveillance 1.

Pour un premier circuit de surveillance 1a de ce système de surveillance 10, une première borne secondaire 61 de chaque interrupteur 6 est reliée électriquement à une première borne primaire 51 d'un seul récepteur de contrôle 41 et la première borne primaire 51 de chaque récepteur de contrôle 41 est reliée électriquement à la première borne secondaire 61 d'un seul interrupteur 6. Les secondes bornes secondaires 62 de chaque interrupteur 6 sont reliées électriquement entre elles ainsi qu'à la seconde borne primaire 52 du récepteur de contrôle 41 de rang *R6* et au récepteur de pied 42, qui, est lui-même relié électriquement à la masse 7 de ce premier circuit de surveillance 1a.

De la sorte, chaque interrupteur 6 est agencé en parallèle avec un ou plusieurs récepteur(s) de contrôle 41 et le cas échéant avec le ou les interrupteur(s) 6 situé(s) en aval de cet interrupteur 6. En conséquence, chaque interrupteur 6 à l'état fermé court-circuite le ou les récepteur(s) de contrôle 41 situé(s) en parallèle de cet interrupteur 6 ainsi que le cas échéant le ou les interrupteur(s) 6 situé(s) également en aval de cet interrupteur 6.

De fait, ce premier circuit de surveillance 1a comporte une hiérarchisation des interrupteurs 6, un interrupteur 6 à l'état fermé masquant chaque interrupteur 6 en aval de sorte que chaque interrupteur 6 en aval soit sans effet sur le premier circuit de surveillance 1a.

Par exemple, l'interrupteur 6 de rang *R3* en position fermée court-circuite les trois récepteurs de contrôle 41 des rangs *R3* à *R6* ainsi que les interrupteurs 6 des rangs *R4* à *R6.* Cet interrupteur 6 de rang *R3* permet donc de masquer les interrupteurs des rangs *R4* à *R6.*

De plus, le changement d'état d'un interrupteur 6 modifie la résistance électrique de l'ensemble électronique 4 qui a des valeurs différentes pour chaque état de chaque interrupteur 6.

Ces différentes valeurs de la résistance électrique de l'ensemble électronique 4 sont prédéfinies en fonction de la résistance électrique de chaque récepteur de contrôle 41. Des valeurs spécifiques d'une seconde tension électrique de réseau *V_{R}* mesurée aux bornes l'ensemble électronique 4 sont préalablement définies pour chaque état de chaque interrupteur 6, en fonction de la tension électrique d'alimentation *V_{A},* de la résistance électrique du récepteur de pied 42 et de l'état de chaque interrupteurs 6 de ce premier circuit de surveillance 1a. Des rapports spécifiques de la seconde tension électrique de réseau *V_{R}* par la tension électrique d'alimentation *V_{A}* correspondant aux différents états de chaque interrupteur 6 sont stockées dans la mémoire 15.

Pour un second circuit de surveillance 1b de ce système de surveillance 10, chaque interrupteur 6 est agencé en parallèle d'un seul récepteur de contrôle 41, chaque borne secondaire 61,62 d'un interrupteur 6 étant reliée à une borne primaire 51,52 de ce récepteur de contrôle 41. De fait, les interrupteurs 6 de ce second circuit de surveillance 1b sont agencés en série.

Dès lors, les deux calculateurs 8, qui sont reliés électriquement aux bornes de chaque circuit de surveillance 1a,1b et aux bornes du récepteur de pied 42 de l'ensemble électronique 4 de chacun de ces deux circuits de surveillance 1a,1b, permettent de mesurer, par l'intermédiaire de leur dispositif de mesure 18 respectif, la seconde tension électrique de réseau *V_{R}* mesurée aux bornes du récepteur de pied 42 de l'ensemble électronique 4 de chacun de ces deux circuits de surveillance 1a,1b ainsi que la tension électrique de référence *V_{A'}* mesurée aux bornes de chacun de ces deux circuits de surveillance 1a, 1b. Les deux calculateurs 8 permettent ensuite de comparer, par l'intermédiaire de leur dispositif d'analyse 19 respectif, le rapport de cette seconde tension électrique de réseau *V_{R}* par la tension électrique de référence *V_{A'}* pour chacun de ces deux circuits de surveillance 1a,1b avec ces rapports spécifiques pour chacun de ces deux circuits de surveillance 1a,1b afin de déterminer l'état de chaque interrupteurs 6 de ces deux circuits de surveillance 1a, 1b.

De plus, pour tous les interrupteurs 6 du premier circuit de surveillance 1a, les deux calculateurs 8 sont capables d'identifier l'interrupteur 6 à l'état fermé de rang le plus faible. Chaque interrupteur 6 de rang inférieur est alors à l'état ouvert et chaque interrupteur de rang supérieur est à un état inconnu car étant court-circuité par cet interrupteur 6 à l'état fermé de rang le plus faible.

Pour le premier circuit de surveillance 1a, les interrupteurs 6 sont à l'état ouvert au repos, à savoir que chaque interrupteur 6 est en position ouverte tant qu'aucune action n'est exercée sur le contacteur de commande 22 correspondant, alors que, pour le second circuit de surveillance 1b, les interrupteurs 6 sont à l'état fermé au repos, à savoir que chaque interrupteur 6 est en position fermée tant qu'aucune action n'est exercée sur le contacteur de commande 22 correspondant.

Par ailleurs, sur la figure 1, le système de surveillance 10 utilise deux sources d'alimentation électrique 2 et deux calculateurs 8 qui sont agencés à l'extérieur de la poignée 21.

Les sources d'alimentation électrique 2 et les calculateurs 8 peuvent également être agencés à l'extérieur de l'organe de contrôle comportant la poignée de commande 20.

Naturellement, la présente invention est sujette à de nombreuses variations quant à sa mise en oeuvre. Bien que plusieurs modes de réalisation aient été décrits, on comprend bien qu'il n'est pas concevable d'identifier de manière exhaustive tous les modes possibles. Il est bien sûr envisageable de remplacer un moyen décrit par un moyen équivalent sans sortir du cadre de la présente invention telle que définie par les revendications. U

Notamment, deux circuits de surveillance 1 peuvent utiliser deux interrupteurs 6 distincts d'un même contacteur de commande 22, comme représenté sur les figures, ces interrupteurs 6 distincts pouvant alors être à l'état ouvert ou fermé au repos. Toutefois, deux circuits de surveillance 1 peuvent également utiliser un même interrupteur 6 d'un contacteur de commande 22, cet interrupteur 6 étant alors à l'état ouvert au repos pour un circuit de surveillance 1 et à l'état fermée au repos pour l'autre circuit de surveillance 1.

## Revendications

1. Système de surveillance (10) redondant et dissimilaire de l'état de contacteurs de commande (22), ledit système de surveillance (10) comportant :
- au moins une source d'alimentation électrique (2) générant un courant électrique avec une tension électrique d'alimentation *VA,*
- au moins un calculateur (8),
- une pluralité de contacteurs de commande (22), chaque contacteur de commande (22) comportant plusieurs interrupteurs (6) pilotés simultanément, et
- au moins deux circuits de surveillance (1) de l'état desdits interrupteurs (6) desdits contacteurs de commande (22), un interrupteur (6) de chaque contacteur de commande (22) étant intégré respectivement à un circuit de surveillance (1), chaque circuit de surveillance (1) étant relié à au moins une source d'alimentation électrique (2) et à au moins un calculateur (8), chaque circuit de surveillance (1) comportant :
• un ensemble électronique (4) comportant un récepteur de pied (42) et au moins deux récepteurs de contrôle (41) agencés en série entre eux, chaque récepteur de contrôle (41) étant muni respectivement de deux bornes primaires (51,52), et
• au moins deux interrupteurs (6) munis respectivement de deux bornes secondaires (61,62), une première borne secondaire (61) d'un interrupteur (6) étant reliée électriquement à une première borne primaire (51) d'un récepteur de contrôle (41) et chaque interrupteur (6) étant agencé en parallèle avec au moins un récepteur de contrôle (41) de sorte à court-circuiter ledit au moins un récepteur de contrôle (41) lorsque ledit interrupteur (6) est à l'état fermé, le nombre desdits interrupteurs (6) étant égal au nombre desdits récepteurs de contrôle (41),
**caractérisé en ce que** chaque calculateur (8) est configuré afin de mesurer au moins une caractéristique électrique dudit ensemble électronique (4) et de déterminer l'état desdits interrupteurs (6) et desdits contacteurs de commande (22).

2. Système de surveillance (10) selon la revendication 1,
**caractérisé en ce que** chaque récepteur de contrôle (41) comporte au moins un dipôle électronique passif.

3. Système de surveillance (10) selon la revendication 2,
**caractérisé en ce que** chaque récepteur de contrôle (41) comporte au moins une diode.

4. Système de surveillance (10) selon l'une quelconque des revendications 2 à 3,
**caractérisé en ce que** chaque récepteur de contrôle (41) comporte au moins une résistance électrique.

5. Système de surveillance (10) selon l'une quelconque des revendications 1 à 4,
**caractérisé en ce que** ledit au moins un calculateur (8) relié audit circuit de surveillance (1) est relié électriquement d'une part aux bornes dudit circuit de surveillance (1) de sorte à mesurer une tension électrique *V_{A'}* aux bornes dudit circuit de surveillance (1), et d'autre part aux bornes dudit ensemble électronique (4) de sorte à mesurer une première tension électrique de réseau *V_{E}* aux bornes dudit ensemble électronique (4), ledit circuit de surveillance (1) comportant un récepteur de tête (3) agencé en série avec ledit ensemble électronique (4), ledit au moins un calculateur (8) étant configuré afin de déterminer un rapport de ladite première tension électrique de réseau *V_{E}* aux bornes dudit ensemble électronique (4) par ladite tension électrique *V_{A'}* aux bornes dudit circuit de surveillance (1) et d'en déduire l'état desdits interrupteurs (6) et desdits contacteurs de commande (22).

6. Système de surveillance (10) selon l'une quelconque des revendications 1 à 4,
**caractérisé en ce que** ledit au moins un calculateur (8) relié audit circuit de surveillance (1) est relié électriquement d'une part aux bornes dudit circuit de surveillance (1) de sorte à mesurer une tension électrique *V_{A'}* aux bornes dudit circuit de surveillance (1) et d'autre part aux bornes dudit récepteur de pied (42) dudit ensemble électronique (4) de sorte à mesurer une seconde tension électrique de réseau *V_{R}* aux bornes dudit récepteur de pied (42), ledit au moins un calculateur (8) étant configuré afin de déterminer un rapport de ladite seconde tension électrique de réseau *V_{R}* aux bornes dudit récepteur de pied (42) par ladite tension électrique *V_{A'}* aux bornes dudit circuit de surveillance (1) et d'en déduire l'état desdits interrupteurs (6) et desdits contacteurs de commande (22).

7. Système de surveillance (10) selon l'une quelconque des revendications 1 à 6,
**caractérisé en ce que** pour au moins un circuit de surveillance (1), une seconde borne secondaire (62) d'un interrupteur (6) est reliée à une seconde borne primaire (52) d'un récepteur de contrôle (41) de sorte que lesdits interrupteurs (6) sont agencés en série entre eux et chaque interrupteur (6) est agencé en parallèle avec un seul récepteur de contrôle (41) afin de court-circuiter ledit récepteur de contrôle (41) lorsque ledit interrupteur (6) est à l'état fermé.

8. Système de surveillance (10) selon l'une quelconque des revendications 1 à 6,
**caractérisé en ce que** pour au moins un circuit de surveillance (1), ledit ensemble électronique (4) comportant n récepteurs de contrôle (41), *n* étant un nombre entier positif et supérieur ou égal à 2, lesdits interrupteurs (6) sont agencés en parallèle entre eux et une seconde borne secondaire (62) de chaque interrupteur (6) est reliée à une seconde borne secondaire (62) desdits autres interrupteurs (6) de sorte que ledit interrupteur (6) de rang *i, i* étant un nombre entier positif compris entre 1 et n, est agencé en parallèle avec *(n-i+1)* récepteur(s) de contrôle (41) afin de court-circuiter lesdits *(n-i+1)* récepteur(s) de contrôle (41) et *(n-i)* interrupteur(s) (6) de rang supérieur au rang i lorsque ledit interrupteur (6) de rang i est à l'état fermé.

9. Système de surveillance (10) selon l'une quelconque des revendications 1 à 6,
**caractérisé en ce que** pour au moins un circuit de surveillance (1), ledit ensemble électronique (4) comportant *n* récepteurs de contrôle (41), *n* étant un nombre entier positif et supérieur ou égal à *2,* lesdits interrupteurs (6) de rang *j, j* étant un nombre entier positif compris entre *1* et *m,* m étant un nombre entier positif compris entre *1* et *n,* lesdits interrupteurs (6) sont agencés en série entre eux de sorte que chaque interrupteur (6) de rang *j* soit agencé en parallèle avec un seul récepteur de contrôle (41) afin de court-circuiter ledit récepteur de contrôle (41) lorsque ledit interrupteur (6) de rang *j* est à l'état fermé, et lesdits interrupteurs (6) de rang *k, k* étant un nombre entier positif compris entre *(m+1)* et *n,* sont agencés en parallèle entre eux, une seconde borne secondaire (62) de chaque interrupteur (6) de rang *k* étant reliée à une seconde borne secondaire (62) desdits interrupteurs (6) de rang *(m+1)* à *n* de sorte que chaque interrupteur (6) de rang *k* est agencé en parallèle avec *(n-k+1)* récepteur(s) de contrôle (41) afin de court-circuiter lesdits *(n-k+1)* récepteur(s) de contrôle (41) et *(n-k)* interrupteur(s) (6) de rang supérieur au rang *k* lorsque ledit interrupteur (6) de rang *k* est à l'état fermé.

10. Système de surveillance (10) selon l'une quelconque des revendications 1 à 9,
**caractérisé en ce qu'**au moins un contacteur de commande (22) comporte au moins deux interrupteurs (6) ayant des états différents au repos et que lesdits circuits de surveillance (1) reliés audits au moins deux interrupteurs (6) sont différents et dissimilaires.

11. Poignée de commande (20) comportant une poignée (21) et des contacteurs de commande (22),
**caractérisée en ce que** ladite poignée de commande (20) comporte un système de surveillance (10) redondant et dissimilaire de l'état de contacteurs de commande (22) selon l'une quelconque des revendications 1 à 10, chaque contacteur de commande (22) comportant plusieurs interrupteurs (6) pilotés de façon simultanée.

12. Poignée de commande (20) selon la revendication 11,
**caractérisée en ce qu'**au moins une source d'alimentation électrique (2) dudit système de surveillance (10) est agencée en dehors de ladite poignée de commande (20).

13. Poignée de commande (20) selon la revendication 11 à 12,
**caractérisée en ce qu'**au moins un calculateur (8) dudit système de surveillance (10) est agencé en dehors de ladite poignée de commande (20).

## Patentansprüche

1. Redundantes und ungleichartiges System zur Überwachung (10) des Status von Steuerschützen (22), wobei das Überwachungssystem (10) umfasst:
- mindestens eine elektrische Stromquelle (2), die einen elektrischen Strom mit einer elektrischen Versorgungsspannung VA erzeugt,
- mindestens einen Rechner (8),
- eine Mehrzahl von Steuerschützen (22), wobei jedes Steuerschütz (22) mehrere gleichzeitig angesteuerte Schalter (6) aufweist, und
- mindestens zwei Schaltungen (1) zur Überwachung des Zustands der Schalter (6) der Steuerschütze (22), wobei ein Schalter (6) jedes Steuerschützes (22) jeweils in eine Überwachungsschaltung (1) integriert ist, wobei jede Überwachungsschaltung (1) mit mindestens einer Stromversorgungsquelle (2) und mit mindestens einem Rechner (8) verbunden ist, wobei jede Überwachungsschaltung (1) umfasst:
- eine elektronische Baugruppe (4) mit einem Fußempfänger (42) und mindestens zwei Kontrollempfängern (41), die in Reihe zueinander angeordnet sind, wobei jeder Kontrollempfänger (41) jeweils mit zwei Primäranschlüssen (51, 52) versehen ist, und
- mindestens zwei Schalter (6) mit je zwei Sekundäranschlüssen (61, 62), wobei ein erster Sekundäranschluss (61) eines Schalters (6) elektrisch mit einem ersten Primäranschluss (51) eines Kontrollempfängers (41) verbunden ist und jeder Schalter (6) parallel zu mindestens einem Kontrollempfänger (41) angeordnet ist, so dass er den mindestens einen Kontrollempfänger (41) kurzschließt, wenn sich der Schalter (6) im geschlossenen Zustand befindet, wobei die Anzahl der besagten Schalter (6) gleich der Anzahl der besagten Kontrollempfänger (41) ist,
**dadurch gekennzeichnet, dass** jeder Rechner (8) konfiguriert ist, um mindestens eine elektrische Eigenschaft der elektronischen Baugruppe (4) zu messen und den Zustand der Schalter (6) und der Steuerschütze (22) zu bestimmen.

2. Überwachungssystem (10) nach Anspruch 1,
**dadurch gekennzeichnet, dass** jeder Kontrollempfänger (41) mindestens einen passiven elektronischen Dipol umfasst.

3. Überwachungssystem (10) nach Anspruch 2,
**dadurch gekennzeichnet, dass** jeder Kontrollempfänger (41) mindestens eine Diode umfasst.

4. Überwachungssystem (10) nach einem der Ansprüche 2 bis 3,
**dadurch gekennzeichnet, dass** jeder Kontrollempfänger (41) mindestens einen elektrischen Widerstand umfasst.

5. Überwachungssystem (10) nach einem der Ansprüche 1 bis 4,
**dadurch gekennzeichnet, dass** der mindestens eine mit der Überwachungsschaltung (1) verbundene Rechner (8) elektrisch einerseits mit den Anschlüssen der Überwachungsschaltung (1) verbunden ist, um eine elektrische Spannung V_{A'} an den Anschlüssen der Überwachungsschaltung (1) zu messen, und andererseits mit den Anschlüssen der elektronischen Baugruppe (4) verbunden ist, um eine erste elektrische Netzspannung V_{E} an den Anschlüssen der elektronischen Baugruppe (4) zu messen, wobei die Überwachungsschaltung (1) einen Kopfempfänger (3) umfasst, der in Reihe mit der elektronischen Baugruppe (4) angeordnet ist, wobei der mindestens eine Rechner (8) konfiguriert ist, um ein Verhältnis der ersten elektrischen Netzspannung V_{E} an den Anschlüssen der elektronischen Baugruppe (4) zu der elektrischen Spannung V_{A'} an den Anschlüssen der Überwachungsschaltung (1) zu bestimmen und daraus den Zustand der Schalter (6) und der Steuerschütze (22) abzuleiten.

6. Überwachungssystem (10) nach einem der Ansprüche 1 bis 4,
**dadurch gekennzeichnet, dass** der mindestens eine mit der Überwachungsschaltung (1) verbundene Rechner (8) elektrisch einerseits mit den Anschlüssen der Überwachungsschaltung (1) verbunden ist, um eine elektrische Spannung V_{A'} an den Anschlüssen der Überwachungsschaltung (1) zu messen, und andererseits mit den Anschlüssen des Fußempfängers (42) der elektronischen Baugruppe (4) verbunden ist, um eine zweite elektrische Netzspannung V_{R} an den Anschlüssen des Fußempfängers (42) zu messen, wobei der mindestens eine Rechner (8) konfiguriert ist, um ein Verhältnis der zweiten elektrischen Netzspannung V_{R} an den Anschlüssen des Fußempfängers (42) zu der elektrischen Spannung V_{A} den Anschlüssen der Überwachungsschaltung (1) zu bestimmen und daraus den Zustand der Schalter (6) und der Steuerschütze (22) abzuleiten.

7. Überwachungssystem (10) nach einem der Ansprüche 1 bis 6,
**dadurch gekennzeichnet, dass** für mindestens eine Überwachungsschaltung (1) ein zweiter sekundärer Anschluss (62) eines Schalters (6) mit einem zweiten primären Anschluss (52) eines Steuerempfängers (41) verbunden ist, so dass die Schalter (6) in Reihe zueinander angeordnet sind und jeder Schalter (6) parallel zu einem einzelnen Steuerempfänger (41) angeordnet ist, um den Steuerempfänger (41) kurzzuschließen, wenn sich der Schalter (6) im geschlossenen Zustand befindet.

8. Überwachungssystem (10) nach einem der Ansprüche 1 bis 6,
**dadurch gekennzeichnet, dass** für mindestens eine Überwachungsschaltung (1), wobei die elektronische Baugruppe (4) n Kontrollempfänger (41) umfasst und n eine positive ganze Zahl und größer oder gleich 2 ist, die Schalter (6) parallel zueinander angeordnet sind und ein zweiter sekundärer Anschluss (62) jedes Schalters (6) mit einem zweiten sekundären Anschluss (62) der anderen Schalter (6) verbunden ist, so dass der Schalter (6) mit dem Rang i, wobei i eine positive ganze Zahl zwischen 1 und n ist, parallel zu (n-i+ 1) Steuerempfänger(n) (41) angeordnet ist, um, wenn sich der Schalter (6) mit dem Rang i im geschlossenen Zustand befindet, die (n-i+ 1) Steuerempfänger (41) und (n-i) Schalter (6) mit einem höheren Rang als dem Rang i kurzzuschließen.

9. Überwachungssystem (10) nach einem der Ansprüche 1 bis 6,
**dadurch gekennzeichnet, dass** bei mindestens einer Überwachungsschaltung (1), wobei die elektronische Baugruppe (4) n Kontrollempfänger (41) umfasst und n eine positive ganze Zahl und größer oder gleich 2 ist, die Schalter (6) vom Rang j, wobei j eine positive ganze Zahl zwischen 1 und m ist und m eine positive ganze Zahl zwischen 1 und n ist, die Schalter (6) in Reihe zueinander angeordnet sind, so dass jeder Schalter (6) mit dem Rang j parallel zu einem einzelnen Kontrollempfänger (41) angeordnet ist, um den Kontrollempfänger (41) kurzzuschließen, wenn sich der Schalter (6) der Reihe j im geschlossenen Zustand befindet, und die Schalter (6) vom Rang k, wobei k eine positive ganze Zahl zwischen (m+1) und n ist, parallel zueinander angeordnet sind, wobei ein zweiter sekundärer Anschluss (62) jedes Schalters (6) vom Rang k mit einem zweiten sekundären Anschluss (62) der Schalter (6) vom Rang (m+1) bis n verbunden ist, so dass jeder Schalter (6) vom Rang k parallel zu (n-k+1) Kontrollempfänger(n) (41) angeordnet ist, um die (n-k+1) Kontrollempfänger (41) und (n-k) Schalter (6) vom Rang größer als Rang k kurzzuschließen, wenn sich der Schalter (6) vom Rang k im geschlossenen Zustand befindet.

10. Überwachungssystem (10) nach einem der Ansprüche 1 bis 9,
**dadurch gekennzeichnet, dass** mindestens ein Steuerschütz (22) mindestens zwei Schalter (6) mit im Ruhezustand unterschiedlichen Zuständen aufweist und dass die Überwachungsschaltungen (1), die mit den mindestens zwei Schaltern (6) verbunden sind, verschieden und ungleichartig sind.

11. Steuergriff (20) mit einem Handgriff (21) und Steuerschützen (22),
**dadurch gekennzeichnet, dass** der Steuergriff (20) ein redundantes und ungleichartiges Überwachungssystem (10) für den Zustand von Steuerschützen (22) nach einem der Ansprüche 1 bis 10 umfasst, wobei jedes Steuerschütz (22) mehrere gleichzeitig angesteuerte Schalter (6) umfasst.

12. Steuergriff (20) nach Anspruch 11,
**dadurch gekennzeichnet, dass** mindestens eine Stromversorgungsquelle (2) des Überwachungssystems (10) außerhalb des Steuergriffs (20) angeordnet ist.

13. Steuergriff (20) nach Anspruch 11 bis 12,
**dadurch gekennzeichnet, dass** mindestens ein Rechner (8) des Überwachungssystems (10) außerhalb des Steuergriffs (20) angeordnet ist.

## Claims

1. Redundant and dissimilar monitoring system (10) for monitoring the status of control contactors (22), said monitoring system (10) comprising:
- at least one electrical power source (2) generating an electric current with an electrical power supply voltage *VA,*
- at least one calculator (8),
- a plurality of control contactors (22), each control contactor (22) comprising several switches (6) controlled simultaneously, and
- at least two monitoring circuits (1) for monitoring the status of said switches (6) of said control contactors (22), one switch (6) of each control contactor (22) being respectively integrated in one monitoring circuit (1), each monitoring circuit (1) being connected to at least one electrical power source (2) and to at least one calculator (8), each monitoring circuit (1) comprising:
• an electronic unit (4) comprising a bottom receiver (42) and at least two control receivers (41) arranged in series with each other, each control receiver (41) being equipped respectively with two primary terminals (51, 52), and
• at least two switches (6) equipped respectively with two secondary terminals (61, 62), a first secondary terminal (61) of a switch (6) being electrically connected to a first primary terminal (51) of a control receiver (41) and each switch (6) being arranged in parallel with at least one control receiver (41) so as to short-circuit said at least one control receiver (41) when said switch (6) is in the closed status, the number of said switches (6) being equal to the number of said control receivers (41),
**characterised in that** each calculator (8) is configured so as to measure at least one electrical characteristic of said electronic unit (4) and to determine the status of said switches (6) and said control contactors (22).

2. Monitoring system (10) according to claim 1,
**characterised in that** each control receiver (41) comprises at least one passive electronic dipole.

3. Monitoring system (10) according to claim 2,
**characterised in that** each control receiver (41) comprises at least one diode.

4. Monitoring system (10) according to either one of claims 2 to 3,
**characterised in that** each control receiver (41) comprises at least one electrical resistance.

5. Monitoring system (10) according to any one of claims 1 to 4,
**characterised in that** said at least one calculator (8) connected to said monitoring circuit (1) is electrically connected on one hand to the terminals of said monitoring circuit (1) so as to measure an electrical voltage *V_{A'}* at the terminals of said monitoring circuit (1), and on the other at the terminals of said electronic unit (4) so as to measure a first network electrical voltage *V_{E}* at the terminals of said electronic unit (4), said monitoring circuit (1) comprising a top receiver (3) arranged in series with said electronic unit (4), said at least one calculator (8) being configured so as to determine a ratio of said first network electrical voltage *V_{E}* at the terminals of said electronic unit (4) to said electrical voltage *V_{A'}* at the terminals of said monitoring circuit (1) and to deduce therefrom the status of said switches (6) and said control contactors (22).

6. Monitoring system (10) according to any one of claims 1 to 4,
**characterised in that** said at least one calculator (8) connected to said monitoring circuit (1) is electrically connected on one hand to the terminals of said monitoring circuit (1) so as to measure an electrical voltage *V_{A'}* at the terminals of said monitoring circuit (1), and on the other at the terminals of said bottom receiver (42) of said electronic unit (4) so as to measure a second network electrical voltage *V_{R}* at the terminals of said bottom receiver (42), said at least one calculator (8) being configured so as to determine a ratio of said second network electrical voltage *V_{R}* at the terminals of said bottom receiver (42) to said electrical voltage *V_{A'}* at the terminals of said monitoring circuit (1) and to deduce therefrom the status of said switches (6) and said control contactors (22).

7. Monitoring system (10) according to any one of claims 1 to 6,
**characterised in that** for at least one monitoring circuit (1), a second secondary terminal (62) of a switch (6) is connected to a second primary terminal (52) of a control receiver (41) such that said switches (6) are arranged in series with each other and each switch (6) is arranged in parallel with a single control receiver (41) so as to short-circuit said control receiver (41) when said switch (6) is in the closed status.

8. Monitoring system (10) according to any one of claims 1 to 6,
**characterised in that** for at least one monitoring circuit (1), said electronic unit (4) comprising *n* control receivers (41), *n* being a positive integer greater than or equal to 2, said switches (6) are arranged in parallel with each other and a second secondary terminal (62) of each switch (6) is connected to a second secondary terminal (62) of said other switches (6) such that said switch (6) of row *i, i* being a positive integer between *1* and *n,* is arranged in parallel with *(n-i+1)* control receiver(s) (41) so as to short-circuit said *(n-i+1)* control receiver(s) (41) and *(n-i)* switch(es) (6) of a row above row i when said switch (6) of row *i* is in the closed status.

9. Monitoring system (10) according to any one of claims 1 to 6,
**characterised in that** for at least one monitoring circuit (1), said electronic unit (4) comprising *n* control receivers (41), *n* being a positive integer greater than or equal to *2,* said switches (6) of row *j*, *j* being a positive integer between *1* and *m*, *m* being a positive integer between *1* and *n,* said switches (6) are arranged in series with each other such that each switch (6) of row *j* is arranged in parallel with a single control receiver (41) so as to short-circuit said control receiver (41) when said switch (6) of row *j* is in the closed status and said switches (6) of row *k, k* being a positive integer between *(m+1)* and *n,* are arranged in parallel with each other, a second secondary terminal (62) of each switch (6) of row k being connected to a second secondary terminal (62) of said switches (6) of row *(m+1)* to n such that each switch (6) of row *k* is arranged in parallel with *(n-k+1)* control receivers (41) so as to short-circuit said *(n-k+1)* control receivers (41) and *(n-k)* switch(es) (6) of a row above row *k* when said switch (6) of row A-is in the closed status.

10. Monitoring system (10) according to any one of claims 1 to 9,
**characterised in that** at least one control contactor (22) comprises at least two switches (6) having different status at rest and that said monitoring circuits (1) connected to said at least two switches (6) are different and dissimilar.

11. Control handgrip (20) comprising a handgrip (21) and control contactors (22),
**characterised in that** said control handgrip (20) comprises a redundant and dissimilar monitoring system (10) for monitoring the status of the control contactors (22) according to any one of claims 1 to 10, each control contactor (22) comprising several switches (6) controlled in a simultaneous manner.

12. Control handgrip (20) according to claim 11,
**characterised in that** at least one electrical power source (2) of said monitoring system (10) is arranged outside said control handgrip (20).

13. Control handgrip (20) according to claim 11 to 12,
**characterised in that** at least one calculator (8) of said monitoring system (10) is arranged outside said control handgrip (20).
